# EUROPEAN PATENT APPLICATION

(11) **EP 4 407 393 A1**
(43) Date of publication of application: **31.07.2024**
(21) Application number: 21958341.6
(22) Date of filing: 21.09.2021
(51) Int. Cl.: G05B 19/418, H05K 13/00, H05K 13/02

(54) **WORK DEVICE AND MOUNTING SYSTEM**

(71) Applicant: Fuji Corporation, Chiryu-shi, Aichi 472-8686 (JP)
(72) Inventor: MIZUNO, Sota, Chiryu-shi, Aichi 472-8686 (JP)
(74) Representative: Grünecker Patent- und Rechtsanwälte PartG mbB
(86) International application number: PCT/JP2021/034588
(87) International publication number: WO 2023/047464

(57) **Abstract**

A work device includes a detection section and a light receiver in a work device main body. The detection section includes a first detection range and a second detection range including at least a detection range outside the first detection range in a traveling direction of the work device main body. The light receiver can receive light from a light projector installed in a member provided on a movement path of the work device main body and has a third detection range between the light projector and the light receiver. When an interfering object in a second detection range is not detected, the work device sets a periphery of the work device main body to the first detection range. When the interfering object in the first detection range is detected, a movement of the work device main body is restricted. Meanwhile, when the interfering object in the second detection range is detected, the work device sets a range not including the third detection range in the periphery of the work device main body to the first detection range. When the interfering object in the first detection range is detected or the interfering object in the third detection range is detected by the light receiver, the movement of the work device main body is restricted.

## Description

### Technical Field

The present description discloses a work device and a mounting system.

### Background Art

Conventionally, in a production line in which multiple component mounters are arranged, there has been proposed a device including a loader (work device) which moves along the line to replenish a tape feeder necessary for each component mounter or collect a used tape feeder (for example, refer to Patent Literature 1). In the component mounter, the tape feeder is detachably mounted by the loader, and a tray feeder is detachably mounted so as to protrude forward from the component mounter and close a traveling path of the loader. The loader includes a light receiver in addition to a monitoring sensor (laser scanner) that detects an interfering object around the loader. The light receiver constitutes a safety curtain in combination with a light projector installed in the tray feeder, and monitors presence or absence of the interfering object between the light projector and the light receiver. The loader determines whether light (safety curtain) from the light projector is detected by the light receiver, and sets a sensor monitoring area of the monitoring sensor to an area 1 around the loader when the safety curtain is not detected. When the interfering object is detected in the area 1 during traveling, the loader stops traveling until the interfering object is no longer detected. Meanwhile, when the loader determines that the safety curtain is detected, the loader calculates a distance between the loader and the tray feeder, and when the calculated distance is less than a predetermined distance, the loader sets the sensor monitoring area to an area 2 narrower than the area 1 so that the monitoring sensor does not detect the tray feeder when the loader approaches the tray feeder. When the interfering object is detected in either the area 2 or the safety curtain during traveling, the loader stops traveling until the interfering object is no longer detected. Accordingly, the loader can appropriately detect the interfering object on the traveling path, and can approach the vicinity of the tray feeder to perform necessary work.

### Patent Literature

Patent Literature 1: WO2019/016924A

### Summary of the Invention

### Technical Problem

However, in the above-described system, in order to switch the sensor monitoring area, it is necessary to calculate the distance between the loader and the tray feeder by acquiring the position of the tray feeder through communication in addition to determining whether the safety curtain is detected by the light receiver, and the processing is complicated.

A main object of the present disclosure is to enable work in the vicinity of a member installed on a movement path while monitoring presence or absence of an interfering object in the vicinity by simple processing.

### Solution to Problem

The present disclosure employs the following means in order to achieve the main object described above.

According to an aspect of the present disclosure, there is provided a work device configured to perform work on a mounting device in a mounting line in which multiple mounting devices are arranged, the work device including:
a work device main body;
a moving device configured to move the work device main body;
a detection section provided to the work device main body, the detection section including a first detection range and a second detection range, the second detection range including at least a detection range outside the first detection range in a traveling direction of the work device main body, and the detection section being configured to detect presence or absence of an interfering object in each of the first detection range and the second detection range;
a light receiver provided to the work device main body to receive light from a light projector installed in a member provided on a movement path of the work device main body, the light receiver being configured to detect the presence or absence of the interfering object based on a light receiving state with a third detection range defined between the light projector and the light receiver; and
a control section configured to control the moving device to move the work device main body, the control section being configured to, in a case where the interfering object in the second detection range is not detected by the detection section, set a periphery of the work device main body to the first detection range and, when the interfering object in the first detection range is detected by the detection section, restrict a movement of the work device main body, and the control section being configured to, in a case where the interfering object in the second detection range is detected by the detection section, set a range not including the third detection range in the periphery of the work device main body to the first detection range and, when the interfering object in the first detection range is detected by the detection section or the interfering object in the third detection range is detected by the light receiver, restrict the movement of the work device main body.

In the work device of the present disclosure, the work device main body includes the detection section and the light receiver. The detection section includes the first detection range and the second detection range including at least the detection range outside the first detection range in the traveling direction of the work device main body. The light receiver can receive the light from the light projector installed in the member provided on the movement path of the work device main body and has the third detection range between the light projector and the light receiver. When the interfering object in the second detection range is not detected by the detection section, the work device sets the periphery of the work device main body to the first detection range. When the interfering object in the first detection range is detected by the detection section, the movement of the work device main body is restricted. Meanwhile, when the interfering object in the second detection range is detected by the detection section, the work device sets the range not including the third detection range in the periphery of the work device main body to the first detection range. When the interfering object in the first detection range is detected by the detection section or the interfering object in the third detection range is detected by the light receiver, the movement of the work device main body is restricted. Accordingly, it is possible to perform work in the vicinity of the member installed on the movement path of the work device main body while monitoring the presence or absence of the interfering object in the vicinity by simple processing.

According to another aspect of the present disclosure, there is provided a mounting system including:
a mounting line in which multiple mounting devices are arranged;
a work device including a work device main body and a moving device, the moving device being configured to move the work device main body, and the work device being configured to perform work on the mounting device;
a light projector installed on a member provided on a movement path of the work device main body,
in which the work device includes,
a detection section provided to the work device main body, the detection section including a first detection range and a second detection range, the second detection range including at least a detection range outside the first detection range in a traveling direction of the work device main body, and the detection section being configured to detect presence or absence of an interfering object in each of the first detection range and the second detection range,
a light receiver provided to the work device main body to receive light from the light projector, the light receiver being configured to detect the presence or absence of the interfering object based on a light receiving state with a third detection range defined between the light projector and the light receiver, and
a control section configured to control the moving device to move the work device main body, the control section being configured to, in a case where the interfering object in the second detection range is not detected by the detection section, set a periphery of the work device main body to the first detection range and, when the interfering object in the first detection range is detected by the detection section, restrict a movement of the work device main body, and the control section being configured to, in a case where the interfering object in the second detection range is detected by the detection section, set a range not including the third detection range in the periphery of the work device main body to the first detection range and, when the interfering object in the first detection range is detected by the detection section or the interfering object in the third detection range is detected by the light receiver, restrict the movement of the work device main body.

Since the mounting system of the present disclosure includes the work device of the present disclosure described above, it is possible to perform work in the vicinity of the member installed on the movement path of the work device main body while monitoring the presence or absence of the interfering object in the vicinity by simple processing.

### Brief Description of Drawings

Fig. 1 is a schematic configuration view of a component mounting system.
Fig. 2 is a schematic configuration view of a component mounter and a feeder base.
Fig. 3 is a schematic configuration view of a feeder.
Fig. 4 is a schematic configuration view of a loader.
Fig. 5 is a schematic configuration view of the component mounter and a tray feeder.
Fig. 6 is a block diagram illustrating an electric connection relationship of the component mounting system.
Fig. 7 is a diagram illustrating a monitoring area (protection area A and warning area B) by a monitoring sensor.
Fig. 8 is a flowchart illustrating an example of work processing executed by a loader control device.
Fig. 9 is a diagram illustrating an operation of the loader in the vicinity of the tray feeder.
Fig. 10 is a diagram illustrating the operation of the loader in the vicinity of the tray feeder.
Fig. 11 is a diagram illustrating the operation of the loader in the vicinity of the tray feeder.
Fig. 12 is a diagram illustrating the operation of the loader in the vicinity of the tray feeder.
Fig. 13 is a diagram illustrating an operation of the loader in the vicinity of a reflow oven.
Fig. 14 is a diagram illustrating the operation of the loader in the vicinity of the reflow oven.
Fig. 15 is a diagram illustrating the operation of the loader in the vicinity of the reflow oven.
Fig. 16 is a diagram illustrating the operation of the loader in the vicinity of the reflow oven.

### Description of Embodiments

Next, an embodiment of the present disclosure will be described with reference to the drawings.

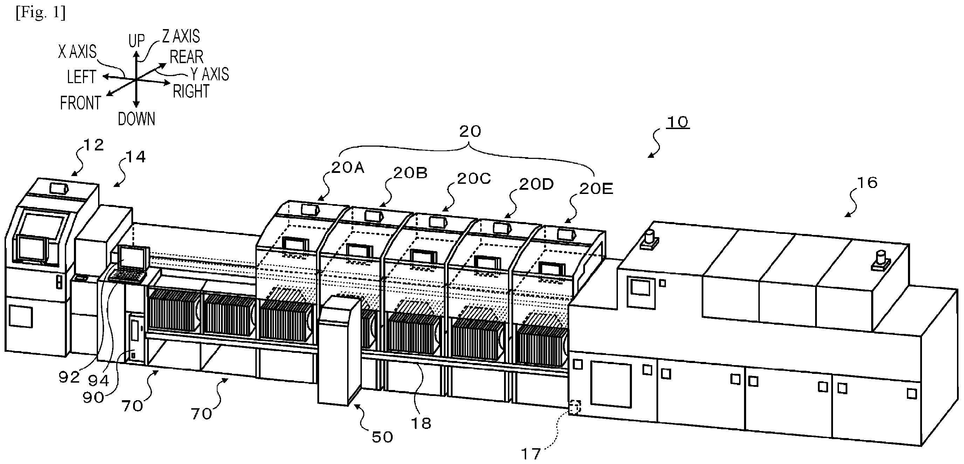

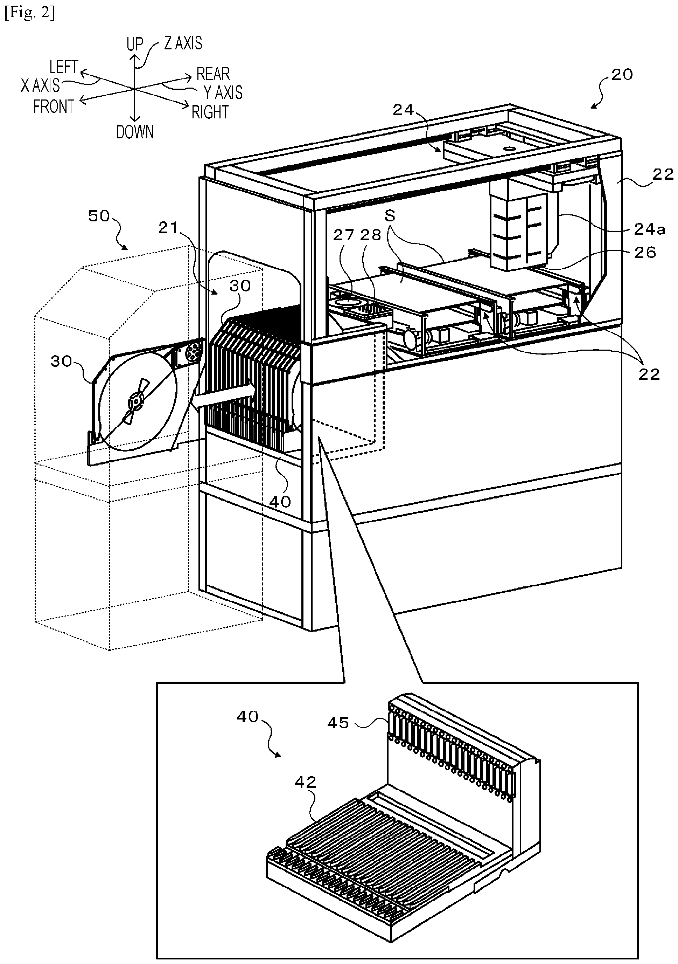

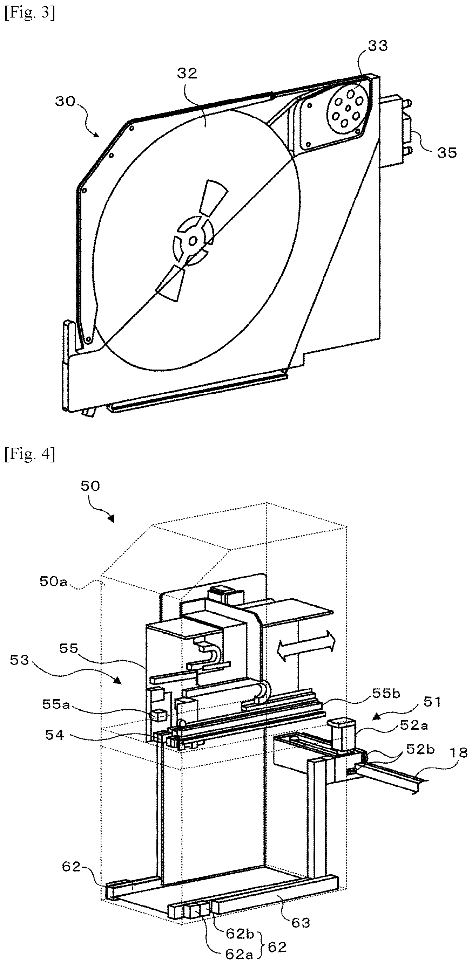

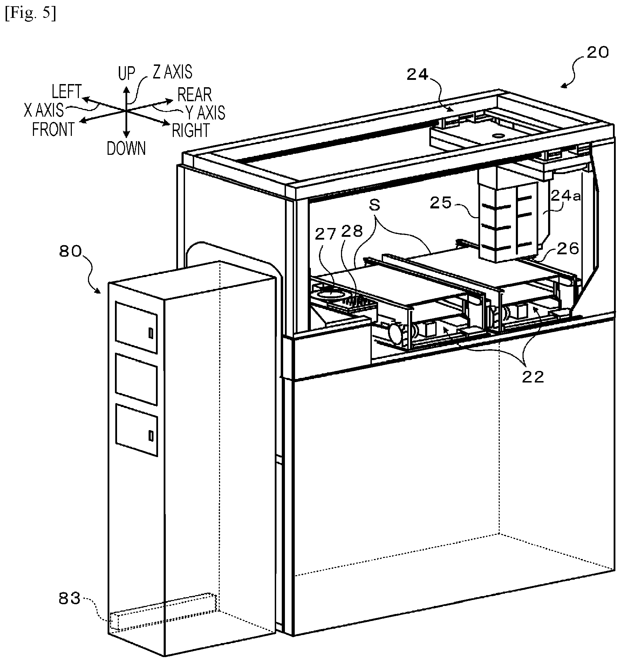

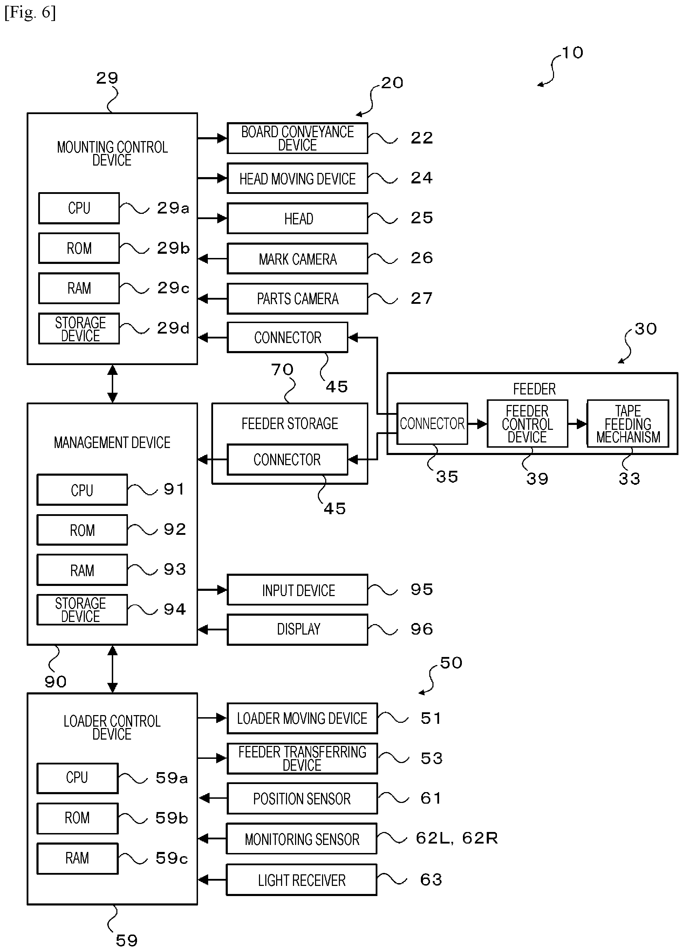

Fig. 1 is a schematic configuration view of a component mounting system. Fig. 2 is a schematic configuration view of a component mounter and a feeder base. Fig. 3 is a schematic configuration view of a feeder. Fig. 4 is a schematic configuration view of a loader. Fig. 5 is a schematic configuration view of the component mounter and a tray feeder. Fig. 6 is a block diagram illustrating an electric connection relationship of the component mounting system. In Figs. 1, 2, 4, and 5, a left-right direction is defined as an X-axis direction, a front-rear direction is defined as a Y-axis direction, and an up-down direction is defined as a Z-axis direction.

Component mounting system 10 is a system for producing board S on which a component is mounted, and includes printing device 12, print inspection device 14, multiple (five) component mounters 20 (20A to 20E), a mounting inspection device (not illustrated), reflow oven 16, loader 50, multiple (two) feeder storages 70, and management device 90 for managing the entire system, as illustrated in Fig. 1. Printing device 12 prints a solder on a front surface of board S. Print inspection device 14 inspects a state of the solder printed by printing device 12. Component mounter 20 collects a component by a suction nozzle (collecting member) and mounts the component on board S. The mounting inspection device inspects a mounting state of the component mounted by component mounter 20. Reflow oven 16 heats board S to melt the solder on board S, thereby soldering the mounted component. In the present embodiment, reflow oven 16 is installed so as to protrude forward from component mounter 20. Printing device 12, print inspection device 14, multiple component mounters 20, the mounting inspection device, and reflow oven 16 are aligned in this order from an upstream along a conveyance direction of board S to constitute a mounting line (production line).

As illustrated in Fig. 2, component mounter 20 includes component supply section 21 that supplies the component, board conveyance device 22 that conveys board S from left to right, head 25 that collects the components supplied from component supply section 21 and mounts the components on board S, head moving device 24 that moves head 25 in a horizontal direction (XY-axis direction), and mounting control device 29 (refer to Fig. 6). Although not illustrated, head 25 includes a suction nozzle for picking up the component and a lifting and lowering device for lifting and lowering the suction nozzle. Head moving device 24 includes slider 24a to which head 25 is attached, and a motor (for example, a linear motor) that moves slider 24a in the horizontal direction (XY direction).

Component supply section 21 is provided in a front portion of component mounter 20, and tape feeder 30 (refer to Fig. 3) and tray feeder 80 (refer to Fig. 5) are detachably mounted on component supply section 21. As illustrated in Figs. 3 and 6, tape feeder 30 includes reel 32 around which a tape in which components are accommodated at predetermined intervals is wound, and supplies the components by drawing out and feeding the tape from reel 32 by tape feeding mechanism 33. Tray feeder 80 includes a tray in which components are arranged, and supplies the components by drawing out the tray by a tray feeding mechanism.

Component mounter 20 also includes mark camera 26, parts camera 27, and nozzle stocker 28. Mark camera 26 captures an image of a reference mark attached to board S from above in order to detect the position of board S. Parts camera 27 captures an image of a component picked up by the suction nozzle from below in order to detect a pickup error or a pickup deviation. Nozzle stocker 28 stocks multiple suction nozzles having different sizes.

Mounting control device 29 includes well-known CPU 29a, ROM 29b, RAM 29c, storage device 29d, and the like. Mounting control device 29 inputs image signals etc., from mark camera 26 and parts camera 27. In addition, mounting control device 29 outputs drive signals to board conveyance device 22, head 25, head moving device 24, and the like.

In addition, mounting control device 29 is communicably connected to feeder control device 39 of tape feeder 30 mounted on feeder base 40 via connectors 35 and 45. When tape feeder 30 is mounted, mounting control device 29 receives feeder information such as a feeder ID, a component type, and the number of remaining components included in feeder control device 39 of tape feeder 30 from feeder control device 39. In addition, mounting control device 29 transmits the received feeder information and a mounting position (slot number) where tape feeder 30 is mounted to management device 90.

CPU 29a of mounting control device 29 executes mounting process for mounting a component on board S. In the mounting process, CPU 29a causes head moving device 24 to move head 25 above the component supply position of tape feeder 30. Subsequently, CPU 29a lowers the suction nozzle by the lifting and lowering device to pick up the component to the suction nozzle. CPU 29a causes the component picked up by the suction nozzle to move above parts camera 27 by head moving device 24, and captures the image of the component by parts camera 27. CPU 29a processes the captured image of the component, measures the pickup deviation amount of the component, and corrects a mounting position of the component on board S. Then, CPU 29a causes the component picked up by the nozzle to move above the corrected mounting position by head moving device 24, and lowers the suction nozzle by the lifting and lowering device to mount the component on board S.

Each of multiple feeder storages 70 is a storage place that is incorporated in a mounting line (between component mounter 20 located on the most upstream side in the board conveyance direction among multiple component mounters 20 and print inspection device 14) and temporarily stores multiple tape feeders 30. For example, tape feeders 30 to be used in each component mounter 20 are stored in a first one of feeder storage 70, and tape feeders 30 used in each component mounter 20 are stored in a second one of feeder storages 70. The replenishment of tape feeder 30 to be used to feeder storage 70 and the collection of used tape feeder 30 are performed by a worker or an automated guided vehicle (AGV).

In each feeder storage 70, a feeder base including multiple slots 42 and connectors 45 similar to feeder base 40 installed in component mounter 20 is installed. When tape feeder 30 is mounted on connector 45 of feeder storage 70, feeder information such as a feeder ID, a component type, and the number of remaining components in tape feeder 30, and the mounting position (slot number) where tape feeder 30 is mounted are transmitted to management device 90.

As illustrated in Fig. 1, loader 50 moves a front surface of component mounting system 10 (mounting line) along the line to detach tape feeder 30 to be used from feeder storage 70 and replenish tape feeder 30 to each component mounter 20, or to collect used tape feeder 30 from each component mounter 20 and convey used tape feeder 30 to feeder storage 70. As illustrated in Figs. 4 and 6, loader 50 includes loader main body 50a, loader moving device 51, feeder transferring device 53, and loader control device 59.

Loader moving device 51 moves loader main body 50a along guide rail 18 disposed in front of the mounting line. Loader moving device 51 includes X-axis motor 52a that drives a driving belt for moving loader main body 50a, and guide roller 52b that rolls on guide rail 18 to guide a movement of loader 50.

Feeder transferring device 53 transfers tape feeder 30 between component mounter 20 and loader 50 at a position where loader 50 faces any of component mounters 20, or transfers tape feeder 30 between feeder storage 70 and loader 50 at a position where loader 50 faces feeder storage 70. Feeder transferring device 53 includes clamp section 54 that clamps tape feeder 30, and Y-axis slider 55 that moves clamp section 54 along Y-axis guide rail 55b. Y-axis slider 55 includes Y-axis motor 55a, and moves clamp section 54 in the front-rear direction (Y-axis direction) by driving Y-axis motor 55a.

Loader control device 59 includes well-known CPU 59a, ROM 59b, RAM 59c, and the like. Loader control device 59 receives detection signals from position sensor 61, two left and right monitoring sensors 62, light receiver 63, and the like. Loader control device 59 outputs drive signals to loader moving device 51 and feeder transferring device 53.

Position sensor 61 is an encoder and detects position P on a movement path of loader main body 50a.

Two left and right monitoring sensors 62 have the vicinity of loader main body 50a as a monitoring area and monitor presence or absence of an interfering object in the monitoring area. Monitoring sensor 62 is configured as, for example, a laser scanner having light projecting section 62a and light receiving section 62b as a sensor section, and detects the presence or absence of the interfering object in the monitoring area by emitting laser light from light projecting section 62a and receiving reflected light from the interfering object by light receiving section 62b. Left monitoring sensor 62 is attached to the left side of loader main body 50a (opposite side to the board conveyance direction), and can mainly detect the interfering object on the left side of loader main body 50a. Right monitoring sensor 62 is attached to the right side (the same side as the board conveyance direction) of loader main body 50a, and can mainly detect the interfering object on the right side of loader 50.

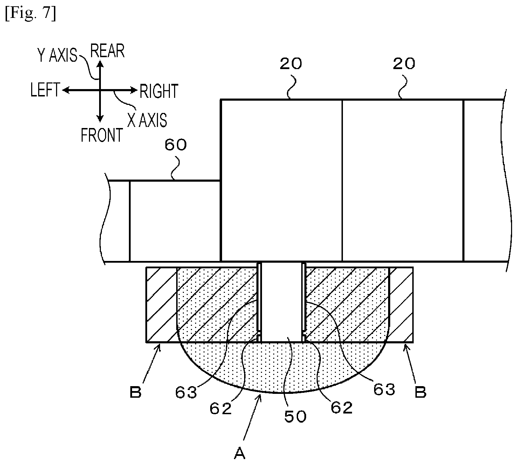

Fig. 7 is a diagram illustrating the monitoring area by monitoring sensor 62. As illustrated, the monitoring area includes protection area A and warning area B. Protection area A is an area that prohibits (restricts) the movement of loader 50 when the interfering object is detected, and is set as a substantially semicircular area around loader 50. Meanwhile, warning area B is an area for monitoring approach of the interfering object to protection area A, and is set as a rectangular area extending outward in the left-right direction from both side surfaces of loader 50 with respect to protection area A.

In the present embodiment, light receiver 63 is installed in loader main body 50a so as to face light projector 83 (refer to Fig. 5) provided in tray feeder 80 when tray feeder 80 is installed in any one of component mounters 20, and to face light projector 17 (refer to Fig. 1) provided on the side surface of the forward protruding portion of reflow oven 16. Light receiver 63 and light projector 17 and 83 constitute safety curtain SC, and each include multiple light receiving elements and multiple light projecting elements arranged in a horizontal direction (front-rear direction) so as to face each other. The multiple light receiving elements normally receive light from the light projecting elements facing each other, and cannot receive the light when the light from the light projecting elements is blocked by the interfering object. Accordingly, safety curtain SC can monitor the presence or absence of the interfering object between light receiver 63 and light projectors 17 and 83 based on the light receiving state of light receiver 63.

Management device 90 is a general-purpose computer and includes CPU 91, ROM 92, RAM 93, and storage device 94, as illustrated in Fig. 6. Input device 95 such as a keyboard and a mouse and display 96 such as a liquid crystal display device are electrically connected to management device 90. Storage device 94 stores a production plan, feeder holding information, job information, status information, and the like. These pieces of information are managed for each component mounter 20. Here, the production plan is a plan for determining which components are mounted in which order in each component mounter 20, and how many boards S (products) mounted as such are manufactured (produced). The feeder holding information is information related to tape feeder 30 held by each component mounter 20 or feeder storage 70. The feeder holding information includes feeder information such as a feeder ID, a component type, and the number of remaining component, and position information such as a device (which component mounter 20 or feeder storage 70) that holds tape feeders 30 (components) and the mounting position (slot number) of tape feeders 30. The job information is information as to the mounting process (job) to be executed by each component mounter 20. The job information includes a type of a board to be produced, a type of a component to be mounted, a mounting position of each component, a component to be mounted by each component mounter 20, and the like. The status information is information indicating the operation status of each component mounter 20. The status information includes during the production, during a changeover, during an abnormality occurrence, and the like.

Management device 90 is communicably connected to mounting control device 29 by wire, and exchanges various information with each component mounter 20 of component mounting system 10. Management device 90 receives the operation status from each component mounter 20 and updates the status information to the latest information. In addition, management device 90 is communicably connected to feeder control device 39 of tape feeder 30 attached to feeder base 40 of each component mounter 20 via mounting control device 29. When tape feeder 30 is detached from component mounter 20 or feeder storage 70, or is attached to component mounter 20 or feeder storage 70, management device 90 receives the attachment and detachment status from corresponding component mounter 20 or corresponding feeder storage 70, and updates the feeder holding information to the latest information.

Further, management device 90 is wirelessly communicably connected to loader control device 59, and manages the operation of loader 50. That is, CPU 91 of management device 90 searches the feeder holding information of feeder storage 70 for components necessary for production of the next type in each component mounter 20 based on the production plan, and transmits a replenishment command to loader 50 so that tape feeder 30 accommodating the corresponding component is replenished to target component mounter 20. Further, CPU 91 transmits a collection command to loader 50 to collect used tape feeder 30 generated in each component mounter 20.

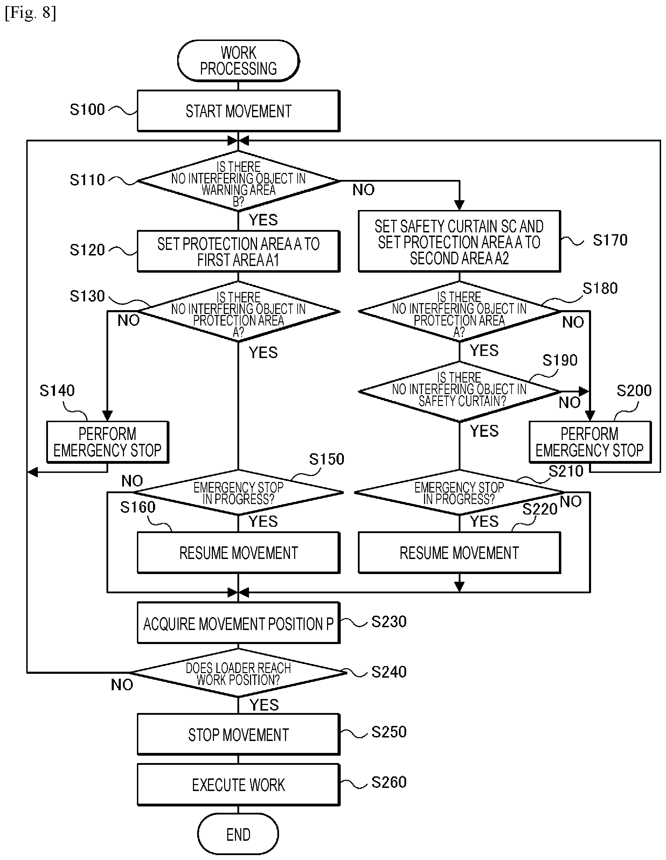

Fig. 8 is a flowchart illustrating an example of work processing executed by loader control device 59. This processing is executed when a work command (the above-described replenishment command or collection command) is received from management device 90. When tray feeder 80 is installed in front of any one of multiple component mounters 20, in order to prevent interference between loader 50 and tray feeder 80, the work position is designated in a range from feeder storage 60 to a position in front of tray feeder 80 in a travelable range, and the work command is transmitted to loader 50.

When the work processing is executed, CPU 59a of loader control device 59 first causes loader moving device 51 to start moving toward the work position (Step S100). Subsequently, CPU 59a determines whether there is the interfering object in warning area B (Step S110). When determining that there is no interfering object in warning area B, CPU 59a sets protection area A to first area A1 (Step S120). Subsequently, CPU 59a determines whether there is the interfering object in protection area A (first area A1) (Step S130). When it is determined that there is the interfering object in protection area A (first area A1), CPU 91 causes loader moving device 51 to stop (emergency stop) the movement of loader 50 (Step S140), and returns to Step S110. When it is determined in Step S130 that there is no interfering object in protection area A (first area A1), CPU 59a determines whether an emergency stop is in progress (Step S150), and when it is determined that the emergency stop is in progress, CPU 59a resumes the movement (Step S160). When it is determined that the emergency stop is not progress, CPU 59a continues the movement because the loader is moving.

When it is determined in Step S110 that there is the interfering object in warning area B, CPU 59a sets safety curtain SC and sets protection area A to second area A2 (Step S170). This processing is processing for preventing an emergency stop before the work position by detecting tray feeder 80 or reflow oven 16 (forward protruding portion) as the interfering object in protection area A (first area A1) when loader 50 moves to the work position in a case where the work position is designated in the vicinity of tray feeder 80 or reflow oven 16 which is a component (system component) of component mounting system 10. When tray feeder 80 is detected in warning area B, second area A2 is set to an area in which a part of first area A1 is cut out by the size of tray feeder 80 so that tray feeder 80 is not detected in protection area A even when loader 50 further approaches tray feeder 80. In addition, second area A2 is set to an area in which a part of first area A1 is cut out by the size of the forward protruding portion of reflow oven 16 so that reflow oven 16 is not detected in protection area A even when loader 50 further approaches reflow oven 16 in a case where reflow oven 16 (forward protruding portion) is detected in warning area B. As described above, in the present embodiment, second area A2 is set to an area in which a part of first area A1 is cut out by different sizes according to the detection position in warning area B. When tray feeder 80 is detected in warning area B, safety curtain SC is set to have the effective range between light receiver 63 provided on the side surface of loader main body 50a and light projector 83 provided on the side surface of tray feeder 80. Further, when reflow oven 16 (forward protruding portion) is detected in warning area B, safety curtain SC is set to have the effective range between light receiver 63 and light projector 17 provided on the side surface of the forward protruding portion of reflow oven 16.

As described above, by changing protection area A of monitoring sensor 62 from first area A1 to second area A2, loader 50 can move to the work position without detecting tray feeder 80 or reflow oven 16 as the interfering object even when the work position is in the vicinity of tray feeder 80 or reflow oven 16. However, in this case, there is a blind spot between loader 50 and tray feeder 80 or between loader 50 and reflow oven 16, and when another interfering object enters this blind spot, loader 50 cannot detect the interfering object and may come into contact with the interfering object. Therefore, in the present embodiment, by covering the blind spot caused by the change of protection area A with safety curtain SC, even when another interfering object enters there, loader 50 can detect the interfering object with safety curtain SC.

Next, CPU 59a determines whether there is the interfering object in protection area A (second area A2) (Step S180) and whether there is the interfering object in safety curtain SC (Step S190). In the processing of Step S190, the presence or absence of the interfering object within the effective range is detected based on whether the light receiving element included in the effective range among the multiple light receiving elements of light receiver 63 receives the light from the light projector. When CPU 59a determines that there is the interfering object in protection area A (second area A2) or determines that there is the interfering object in safety curtain SC, CPU 59a controls loader moving device 51 to stop (emergency stop) the movement of loader 50 (Step S200) and returns to Step S110. When it is determined in Steps S180 and S190 that there is no interfering object in any of protection area A (second area A2) and safety curtain SC, CPU 59a determines whether an emergency stop is in progress (Step S210), and when it is determined that the emergency stop is in progress, CPU 59a resumes traveling (Step S220). When it is determined that the emergency stop is not progress, CPU 59a continues the movement because the loader is moving.

Here, CPU 59a also sets safety curtain SC in Step S170 and sets protection area A to second area A2 even when a worker or the like is detected in warning area B instead of the system components such as tray feeder 80 having light projector 83 and reflow oven 16 having light projector 17. In this case, even when safety curtain SC is set, since light receiver 63 does not actually receive the light from light projectors 17 and 83, CPU 59a determines that there is the interfering object in safety curtain SC and stops the movement of loader 50 (emergency stop). After causing loader 50 to perform an emergency stop, CPU 59a returns to Step S110, and when the worker moves away from warning area B and no interfering object is detected in warning area B ("YES" in Step S1 10), the setting of safety curtain SC is cancelled, and protection area A is returned to first area A1 in Step S120. Accordingly, when the interfering object such as a worker is not detected in protection area A (first area A1), the movement of loader 50 is resumed.

Then, CPU 59a acquires movement position P from position sensor 61 (Step S230), and determines whether the loader reaches the work position based on acquired movement position P (Step S240). When determining that the loader has not reached the work position, CPU 59a returns to Step S110 and continues the movement. Meanwhile, when it is determined that loader 50 has reached the work position, CPU 59a controls loader moving device 51 so as to stop the movement of loader 50 (Step S250), executes the above-described work related to the work command (Step S260), and ends the work processing.

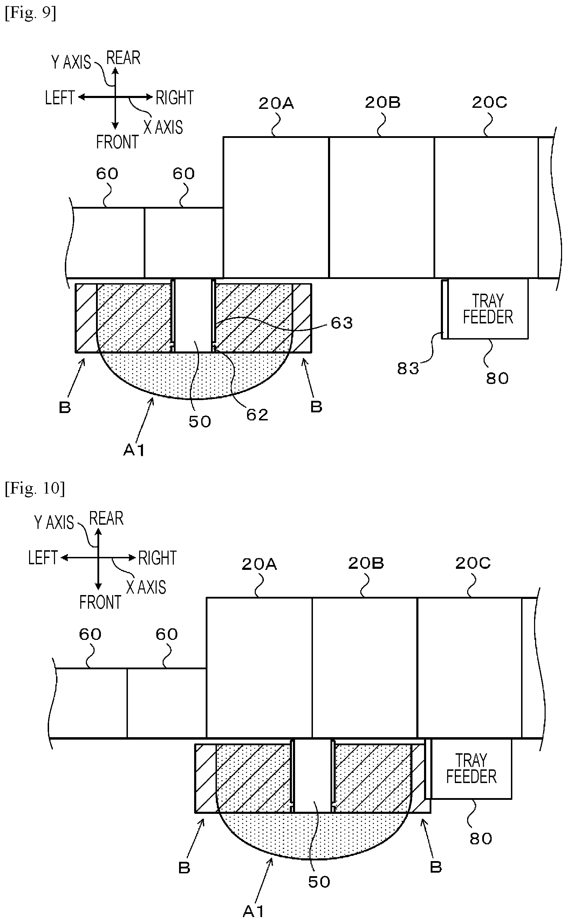

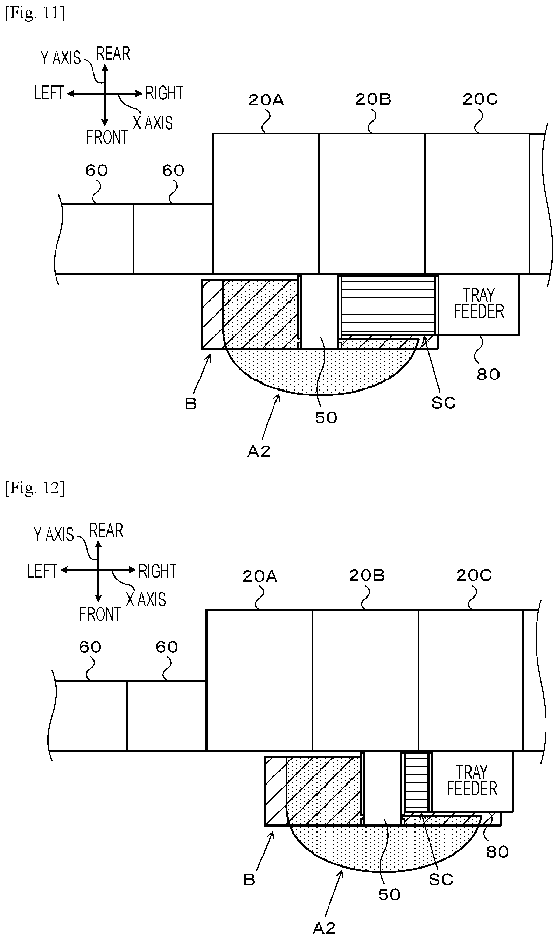

Figs. 9 to 12 are diagrams illustrating a state of the operation of the loader in the vicinity of tray feeder 80. The example of the drawings illustrates a case where tray feeder 80 is installed in component mounter 20C and tape feeder 30 is conveyed from feeder storage 70 to component mounter 20B adjacent to component mounter 20C. As illustrated, while loader 50 is moving, the presence or absence of the interfering object is basically monitored in protection area A (first area A1) and warning area B (refer to Fig. 9). When loader 50 detects tray feeder 80 in warning area B while moving to the work position, loader 50 changes protection area A to second area A2 in which a part of first area A1 is cut out so as not to detect tray feeder 80 in protection area A (refer to Figs. 10 and 11). Accordingly, it is possible to avoid the emergency stop of loader 50 due to detection of tray feeder 80 in protection area A. When protection area A is changed to second area A2, since a blind spot of protection area A is formed between loader 50 and tray feeder 80, loader 50 monitors the blind spot using safety curtain SC instead of protection area A (refer to Fig. 12). When loader 50 arrives at the front surface of component mounter 20C, loader 50 performs work such as exchange or collection of tape feeder 30.

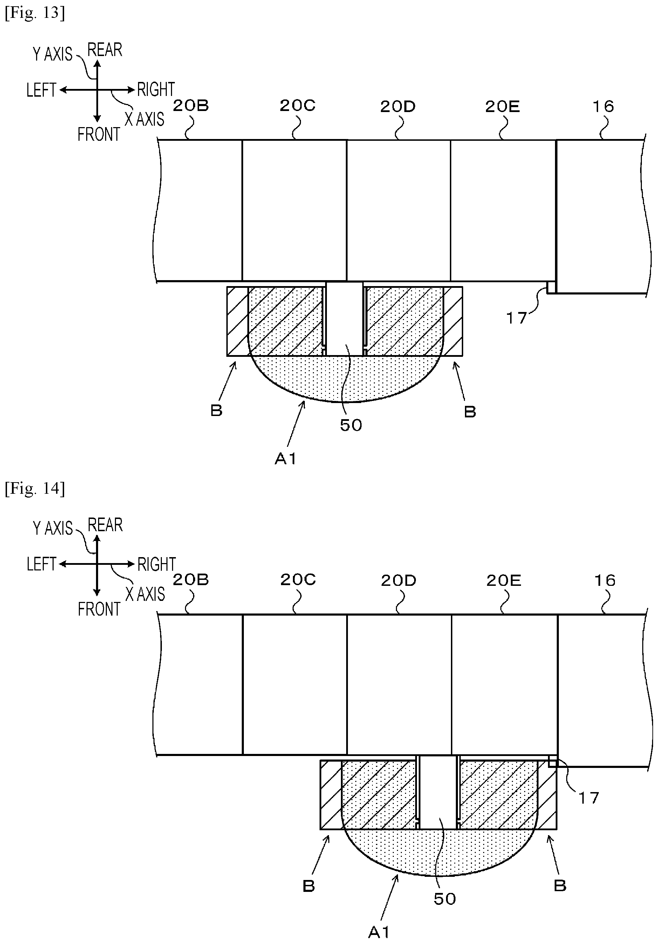

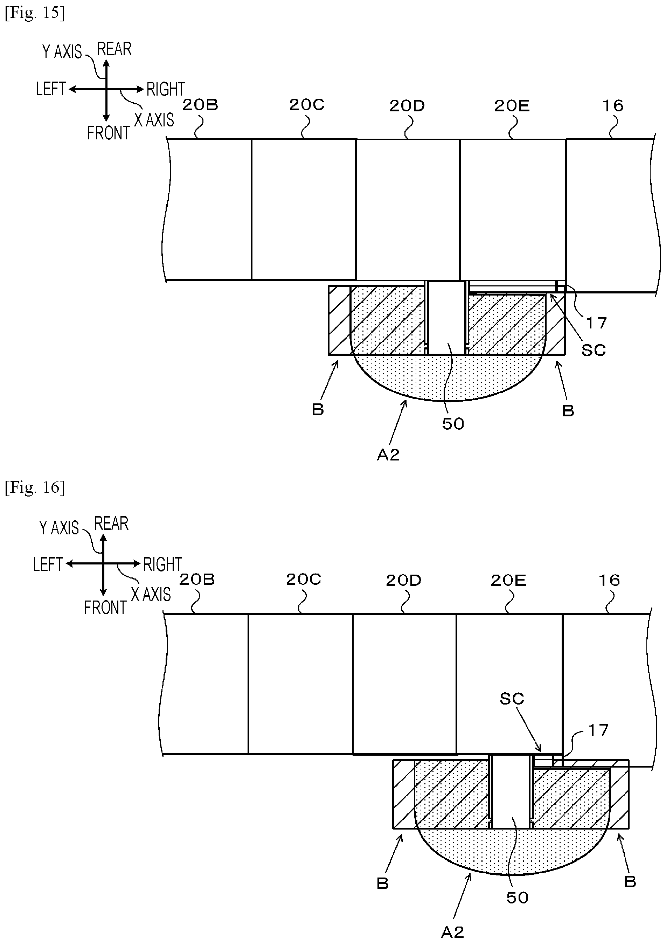

Figs. 13 to 16 are diagrams illustrating the operation of the loader in the vicinity of the reflow oven. In the illustrated example, tape feeder 30 is conveyed to component mounter 20E in which reflow oven 16 is installed downstream. As illustrated in the drawing, in a case where loader 50 moves to the vicinity of reflow oven 16, when first area A1 is set to protection area A, loader 50 detects the forward protruding portion of reflow oven 16 as the interfering object, and an emergency stop occurs. In the present embodiment, when loader 50 detects the forward protruding portion of reflow oven 16 in warning area B while moving to the work position (refer to Figs. 13 and 14), loader 50 changes protection area A to second area A2 in which a part of first area A1 is cut out so as not to detect the forward protruding portion in protection area A (refer to Fig. 15). Accordingly, it is possible to avoid an emergency stop of loader 50 due to the detection of reflow oven 16 in protection area A. When protection area A is changed to second area A2, since the blind spot of protection area A is formed between loader 50 and reflow oven 16 (forward protruding portion), loader 50 monitors the blind spot using safety curtain SC instead of protection area A (refer to Fig. 16). When loader 50 arrives at the front of component mounter 20E, loader 50 performs work such as exchange or collection of tape feeder 30.

Here, a correspondence relationship between principal elements of the present embodiment and principal elements disclosed in the columns of the claims will be described. That is, loader main body 50a of the present embodiment corresponds to a work device main body, loader moving device 51 corresponds to a moving device, monitoring sensor 62 corresponds to a detection section, light receiver 63 corresponds to a light receiver, protection area A corresponds to a first detection range, warning area B corresponds to a second detection range, safety curtain SC corresponds to a third detection range, and loader control device 59 corresponds to a control section. Further, component mounters 20A to 20E correspond to multiple mounting devices, and light projectors 17 and 83 correspond to light projectors.

The present disclosure is not limited in any way to the embodiments described above, and it is needless to say that the present disclosure can be embodied in various aspects as long as the various aspects fall within the technical scope of the present disclosure.

For example, in the above-described embodiment, the work device of the present disclosure is applied to loader 50, but may be applied to an automated guided vehicle (AVG).

As described above, the work device of the present disclosure includes the detection section and the light receiver in the work device main body. The detection section includes he first detection range and the second detection range at least including the detection range outside the first detection range in the traveling direction of the work device main body. The light receiver can receive the light from the light projector installed in the member provided on the movement path of the work device main body and has the third detection range between the light projector and the light receiver. When the interfering object in the second detection range is not detected by the detection section, the work device sets the periphery of the work device main body to the first detection range. When the interfering object in the first detection range is detected by the detection section, the movement of the work device main body is restricted. Meanwhile, when the interfering object in the second detection range is detected by the detection section, the work device sets a range not including the third detection range in the periphery of the work device main body to the first detection range. When the interfering object in the first detection range is detected by the detection section or the interfering object in the third detection range is detected by the light receiver, the movement of the work device main body is restricted. Accordingly, it is possible to perform work in the vicinity of the member installed on the movement path of the work device main body while monitoring the presence or absence of the interfering object in the vicinity by simple processing.

In the work device of the present disclosure, when the interfering object is detected in the second detection range by the detection section, the control section may set the first detection range and the third detection range according to the detection position of the interfering object in the second detection range. In this way, even when multiple members having different sizes are installed on the movement path of the work device main body, it is possible to approach the vicinity of the members while ensuring safety.

In the present disclosure, the work device is configured, but the work device may be configured as the mounting system.

### Industrial Applicability

The present disclosure can be used in a manufacturing industry such as a work device or a mounting system.

### Reference Signs List

10: component mounting system, 12: printing device, 14: print inspection device, 16: reflow oven, 17: light projector, 18: guide rail, 20, 20A, 20B, 20C, 20D, and 20E: component mounter, 21: component supply section, 22: board conveyance device, 24: head moving device, 24a: slider, 25: head, 26: mark camera, 27: parts camera, 28: nozzle stocker, 29: mounting control device, 29a: CPU, 29b: ROM, 29c: RAM, 29d: storage device, 30: tape feeder, 32: reel, 33: tape feeding mechanism, 35: connector, 39: feeder control device, 40: feeder base, 42: slot, 45: connector, 50: loader, 50a: loader main body, 51: loader moving device, 52a: X-axis motor, 52b: guide roller, 53: feeder transferring device, 54: clamp section, 55: Y-axis slider, 55a: Y-axis motor, 55b: Y-axis guide rail, 59: loader control device, 59a: CPU, 59b: ROM, 59c: RAM, 60: feeder storage, 61: position sensor, 62: monitoring sensor, 62a: light projecting section, 62b: light receiving section, 63: light receiver, 70: feeder storage, 80: tray feeder, 83: light projector, 90: management device, 91: CPU, 92: ROM, 93: RAM, 94: storage device, 95: input device, 96: display, A: protection area, A1: first area, A2: second area, B: warning area, SC: safety curtain.

## Claims

1. A work device configured to perform work on a mounting device in a mounting line in which multiple mounting devices are arranged, the work device comprising:
a work device main body;
a moving device configured to move the work device main body;
a detection section provided to the work device main body, the detection section including a first detection range and a second detection range, the second detection range including at least a detection range outside the first detection range in a traveling direction of the work device main body, and the detection section being configured to detect presence or absence of an interfering object in each of the first detection range and the second detection range;
a light receiver provided to the work device main body to receive light from a light projector installed in a member provided on a movement path of the work device main body, the light receiver being configured to detect the presence or absence of the interfering object based on a light receiving state with a third detection range defined between the light projector and the light receiver; and
a control section configured to control the moving device to move the work device main body, the control section being configured to, in a case where the interfering object in the second detection range is not detected by the detection section, set a periphery of the work device main body to the first detection range and, when the interfering object in the first detection range is detected by the detection section, restrict a movement of the work device main body, and the control section being configured to, in a case where the interfering object in the second detection range is detected by the detection section, set a range not including the third detection range in the periphery of the work device main body to the first detection range and, when the interfering object in the first detection range is detected by the detection section or the interfering object in the third detection range is detected by the light receiver, restrict the movement of the work device main body.

2. The work device according to claim 1, wherein the control section is configured to, in a case where the interfering object in the second detection range is detected by the detection section, set the first detection range and the third detection range based on a detection position of the interfering object in the second detection range.

3. A mounting system comprising:
a mounting line in which multiple mounting devices are arranged;
a work device including a work device main body and a moving device, the moving device being configured to move the work device main body, and the work device being configured to perform work on the mounting device; and
a light projector installed on a member provided on a movement path of the work device main body,
wherein
the work device includes:
a detection section provided to the work device main body, the detection section including a first detection range and a second detection range, the second detection range including at least a detection range outside the first detection range in a traveling direction of the work device main body, and the detection section being configured to detect presence or absence of an interfering object in each of the first detection range and the second detection range;
a light receiver provided to the work device main body to receive light from the light projector, the light receiver being configured to detect the presence or absence of the interfering object based on a light receiving state with a third detection range defined between the light projector and the light receiver; and
a control section configured to control the moving device to move the work device main body, the control section being configured to, in a case where the interfering object in the second detection range is not detected by the detection section, set a periphery of the work device main body to the first detection range and, when the interfering object in the first detection range is detected by the detection section, restrict a movement of the work device main body, and the control section being configured to, in a case where the interfering object in the second detection range is detected by the detection section, set a range not including the third detection range in the periphery of the work device main body to the first detection range and, when the interfering object in the first detection range is detected by the detection section or the interfering object in the third detection range is detected by the light receiver, restrict the movement of the work device main body.
